## Europäisches Patentamt
## European Patent Office
## Office européen des brevets

(11) Numéro de publication: **0 140 413**
**B1**

(12) **FASCICULE DE BREVET EUROPÉEN**

(45) Date de publication du fascicule du brevet:
**23.11.88**

(51) Int. Cl.⁴: **G 11 C 11/40**

(21) Numéro de dépôt: **84201315.3**

(22) Date de dépôt: **12.09.84**

(54) Circuit decodeur pour memoire ram statique.

(30) Priorité: **16.09.83 FR 8314774**

(43) Date de publication de la demande:
**08.05.85 Bulletin 85/19**

(45) Mention de la délivrance du brevet:
**23.11.88 Bulletin 88/47**

(84) Etats contractants désignés:
**DE FR GB IT NL**

(56) Documents cité:
**US-A-3 863 230**
**US-A-4 145 622**

**ISSCC, INTERNATIONAL SOLID STATE CIRCUITS CONFERENCE, DIGEST OF TECHNICAL PAPERS, 16 février 1977, vol. 20, no. 20, New York, US; W. LATTIN: "MOS memories"**

(73) Titulaire: **Laboratoires d'Electronique et de Physique Appliquée L.E.P., 3, Avenue Descartes, F-94450 Limeil- Brévannes (FR)**
(84) Etats contractants désignés: **FR**

(73) Titulaire: **N.V. Philips' Gloeilampenfabrieken, Groenewoudseweg 1, NL- 5621 BA Eindhoven (NL)**
(84) Etats contractants désignés: **DE GB IT NL**

(72) Inventeur: **Gabillard, Bertrand, Société Civile S.P.I.D. 209 rue de l'Université, F-75007 Paris (FR)**

(74) Mandataire: **Landousy, Christian, Société Civile S.P.I.D. 209, Rue de l'Université, F-75007 Paris (FR)**

LIBER, STOCKHOLM 1988

**0 140 413**

## Description

L'invention concerne un circuit décodeur pour mémoire RAM statique intégrée monolithiquement, et constitué d'une porte logique NON-OU $P_1$, qui est formée d'une série de transistors à effet de champ dont les grilles reçoivent les n signaux codés d'adressage de la mémoire ou leurs complémentaires, dont les sources sont reliées à la masse et dont les drains sont interconnectés et forment la sortie de la porte NON-OU $P_1$, qui est reliée à une borne d'alimentation $V_{DD1}$ par l'intermédiaire d'une charge et qui est reliée à la grille d'un transistor d'un étage inverseur de sortie.

Les circuits mémoires sont presque toujours organisés sous la forme d'un réseau de cellules qui présente la structure d'une matrice. Chaque cellule, correspondant à un chiffre binaire (en anglais BIT = BInary digiT) est située au croisement de deux lignes, une ligne horizontale ou rangée, une ligne verticale ou colonne. Ces lignes correspondent aux adresses de la mémoire et sont généralement notées $X_1$, $X_2$,... $X_n$ pour les rangées et $Y_1$, $Y_2$,... $Y_n$ pour les colonnes. Ainsi chaque cellule de la mémoire a une adresse unique et peut être sélectionnée en activant simultanément la rangée et la colonne appropriées. Après sélection de la cellule, la donnée peut être transmise à la cellule ou extraite de la cellule par une paire de lignes communes à toutes les cellules dites lignes de BT (en anglais BIT-LINE).

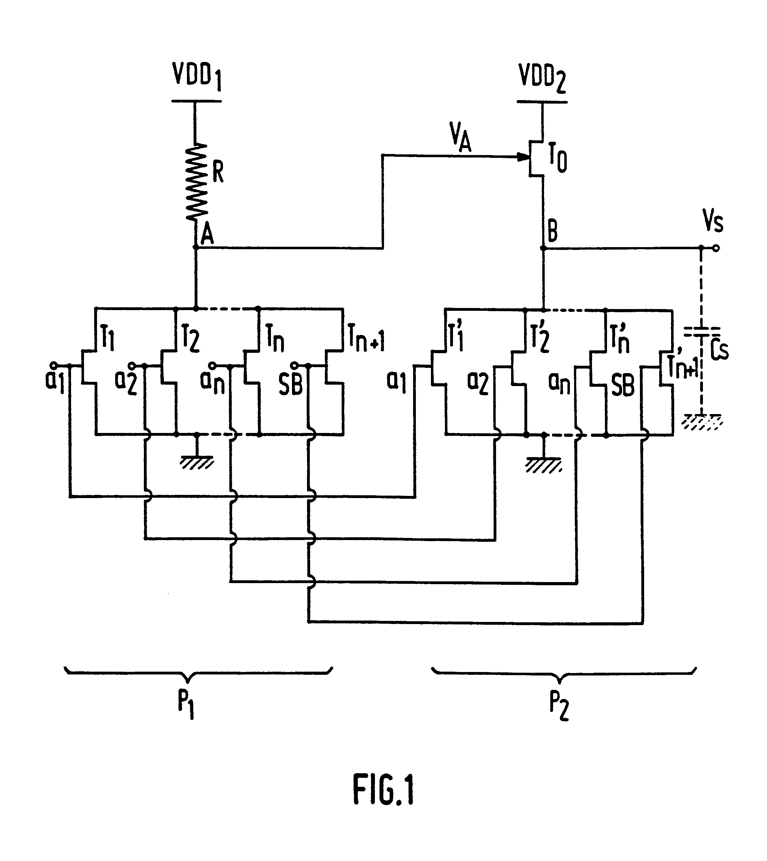

Il est connu par la publication de M. INO et alii (Musashino Electrical Communication Laboratory), dans le compte-rendu "IEEE GaAs I.C. Symposium 1982" sous le titre "GaAs 1Kb Static RAM with E/D MESFET DCFL", de réaliser un circuit décodeur pour une mémoire RAM statique, intégrée monolithiquement sur un substrat en arséniure de gallium (AsGa) et composée de transistors à effet de champ (MESFET: Metal Semiconductor Field Effect Transistor). Un circuit décodeur, tel que décrit dans le document cité et illustré par la figure 1 de la page 4 de ce même document, est composé de circuits décodeurs élémentaires. Chaque décodeurs élémentaires est essentiellement constitué d'une porte NON-OU à n entrées, destinées à recevoir chacune une des entrées d'adresses codée en binaire $a_1$, $a_2$... $a_n$, exprimée sous la forme d'un signal vrai ou bien de son complémentaire, formé avant l'entrée dans le décodeur par un circuit intermédiaire (en anglais ADDRESS BUFFER), de manière à obtenir sur la sortie de la porte NON-OU, une combinaison de ces chiffres binaires, produite par la fonction logique NON-OU et constituant l'adresse d'une ligne ou d'une colonne.

Cette porte NON-OU est formée de transistors à effet de champ en arséniure de gallium, à enrichissement, présentant une tension de pincement $V_T \geqslant 0$, c'est-à-dire ne conduisant pas lant que la tension appliquée sur la grille n'est pas supérieure à cette tension $V_T$. Les transistors constituant cette perte NON-OU sont montés en parallèle, leur source commune étant reliée à la masse et leur drain commun étant relié aux grille-source court-circuitées d'un ransistor à désertion, utilisé comme charge dite active.

Lorsque les valeurs du signal de sortie de la porte NOR passent de 0 à 1 ou de 1 à 0, la tension qui lui est associée charge ou décharge la capacité de sortie du circuit. Afin d'obtenir des temps équivalents pour la charge et la décharce de cette capacité, le signal de sortie de la porte NOR est porté sur l'entrée d'un étage inverseur de manière à pouvoir disposer à la fois du signal de sortie vrai et de son complémentaire, puis ces signaux sont appliqués respectivement chacun sur une des deux entrées d'un étage PUSH-PULL. L'étage inverseur utilisé comporte un transistor à enrichissement comme transistor inverseur et un transistor à désertion comme charge. L'étage PUSH-PULL comporte également un transistor à enrichissement, monté en source commune à la masse, en série avec un transistor à désertion monté en drain commun à la tension d'alimentation.

Dans le cas du circuit décodeur, par exemple, il est intéressant de remplacer les transistors à désertion constituant les charges actives par des charges résistives, plus faciles à réaliser sur le plan technologique. D'autre part, il est intéressant de remplacer le transistor à désertion de l'étage PUSH-PULL par un transistor à enrichissement de manière à n'avoir recours qu'à un seul type de transistors pour la fabrication d'un tel circuit.

Mais si l'on envisage la transposition pure et simple du circuit décrit dans le document cité par la méthode décrite ci-dessus, on se heurte aussitôt au problème suivant il apparaît entre la sortie de la porte NOR et la masse, une diode parasite due au fait que le transistor inverseur, sur lequel est portée cette tension de sortie, est du type Schottky. Cet effet de diode parasite empêche le signal de sortie de la porte NON-OU d'atteindre un niveau suffisant pour débloquer le transistor de l'étage PUSH-PULL sur lequel il est appliqué. L'étage PUSH-PULL est donc rendu inefficace, et dans ces conditions, il devient long et difficile de charger la capacité de sortie du décodeur élémentaire.

L'objet de la présente invention est de fournir un circuit décodeur pour une mémoire RAM statique intégrée, qui permette un accès plus rapide à la cellule mémoire. L'objet de la présente invention est en outre de fournir un circuit décodeur qui soit particulièrement simple à réaliser et qui permette ainsi d'étendre le champ de la production.

Un circuit décodeur conforme à l'invention est remarquable en ce que, la source du transistor de l'étage inverseur est raccordée aux drains communs d'une deuxième série de transistors, qui forment une deuxième porte NON-OU $P_2$, les drains communs formant la sortie du circuit décodeur et les sources des transistors de la deuxième série étant reliées à la masse, en ce que la deuxième série de transistors reçoit sur ses grilles les n signaux codés d'adressage et en ce que la première et la deuxième séries de transistors comportent un transistor de sélection, dont la grille reçoit le signal de sélection du boîtier SB, ce signal de sélection de boîtier étant appliqué aux transistors de sélection après l'applicaton des signaux codés d'adressage de mémoires aux deux portes NON-OU $P_1$, $P_2$.

Dans ces conditions, le fait qu'il n'est pas necessaire d'inclure dans le circuit décodeur élémentaire selon

2

l'invention un étage inverseur entre l'étage décodeur proprement dit et l'étage PUSH-PULL, ce qui était le cas dans le circuit décrit dans le document cité, permet d'obtenir une diminution très conséquente du temps de propagation dans ce circuit. La réduction d'un étage entraîne également une diminution de la puissance consommée, cette diminution de consommation étant d'ailleurs accentuée par le fait que la tension d'alimentation du second étage est inférieure à celle du premier étage.

On notera qu'un circuit décodeur pour une mémoire dynamique est connu du brevet US-3 778 782 Ce circuit est formé de deux portes NON-OU montées en cascade. Ces portes NON-OU sont combinées avec une porte ET et sont contrôlées par des signaux d'horloge pour la précharge et les opérations logiques. Cependant l'enseignement de ce document ne conduit pas à la réalisation d'un circuit décodeur à vitesse élevée conforme à celui de la présente invention. Au contraire, l'utilisation d'un circuit décodeur tel que décrit par le document cité peut donner naissance à des problèmes dont on peut s'affranchir en utilisant les solutions proposées par le brevet US-3 863 230. Ces solutions conduisent à un circuit très éloigne du circuit relativement simple réalisé conformément à la présente invention.

Une forme de réalisation préférentielle du circuit décodeur selon l'invention est caractérisée en ce que les transistors sont tous du type à enrichissement et en ce que la charge de la première porte NON-OU $P_1$ est une charge résistive.

L'utilisation d'un seul type de transistor ainsi que l'utilisation d'une charge résistive au est plus simple à mettre en oeuvre, conduit à un procédé de fabrication moins compliqué, ce qui est particulièrement avantageux dans le cas où ce circuit décodeur est inclus dans un circuit intégré en arséniure de gallium tel qu'un circuit mémoire.

L'invention trouve son application dans la réalisation de mémoires-caches (en anglais cache-memory) ultrarapides pour les gros ordinateurs utilisés dans les domaines de l'astrologie et de la météorologie, ainsi que pour les pocesseurs d'appareils de simulation de vol permettant la visualisation d'images digitalisées à haute résolution.

Pour la réalisation de mémoires-caches, destinées à l'application envisagée, la mise au point de mémoires RAM statiques ultrarapides, de faible consommation et monolithiquement intégrées, est impérative. C'est pourquoi, une technologie comprenant des transistors à effet de champ en arséniure de gallium est extrêmement favorable à la réalisation de tels circuits, du fait de la mobilité électronique particulièrement élevée dans ce matériau, permettant d'obtenir des temps de transit très courts dans les transistors. De plus, entre les différentes technologies actuellement réalisables à l'aide de transistors en arséniure de gallium, la technologie dite DCFL (Direct Coupled Field-effect transistor Logic) est celle qui présente à la fois la plus faible consommation et la plus forte densité d'intégration alliées à une très grande rapidité. La porte logique élémentaire, ou inverseur, réalisée à l'aide de cette technologie, est composée d'un transistor à effet de champ à enrichissement (tension de pincement $V_T \geqslant 0$) associé à une charge, et présente un signal de sortie compatible avec l'entrée de la porte logique suivante.

Ces améliorations, qui permettent d'utiliser un moins grand nombre de transistors, compensent le fait que la seconde porte NON-OU implique un certain nombre de transistors supplémentaires. En fait, au cours de l'implantation du circuit, chaque décodeur élémentaire prend on hauteur la distance entre deux lignes ou deux colonnes de la mémoire. Si la surface occupée par le décodeur élémentaire est inférieure à la surface qui lui est ainsi impartie, la place se trouve perdue. Il se trouve que dans l'implantation de ce circuit à l'aide de la logique choisie, la seconde porte NON-OU appariée avec la première se place très bien sans augmenter la surface prévue pour le décodeur.

L'invention sera mieux comprise grâce à la description détaillée du circuit illustrée par les figures ci-après annexées.

La figure 1 représente le circuit décodeur élémentaire selon l'invention.

La figure 2 représente le point mémoire de la mémoire RAM statique associée au circuit décodeur élémentaire selon l'invention.

Les figures 3a et 3b représentent le diagramme de propagation du signal $V_S$ sur la ligne de MOT par rapport au signal de sélection du boîtier SB et par rapport au signal ai de sélection des adresses $a_1$, $a_2$ ... $a_n$, en fonction du temps t.

Tel que représenté sur la figure 1, le circuit décodeur élémentaire, selon l'invention, comporte une première porte NON-OU $P_1$ constituée de $n+1$ transistors à effet de champ à enrichissement, n étant le nombre des signaux codés d'adressage de la mémoire. Sur n des entrées de cette première porte NON-OU $P_1$ sont appliqués les n dits signaux codés d'adressage destinés à fournir la combinaison constituant l'adresse d'une ligne ou d'une colonne. Sur la dernière entrée de cette porte NON-OU $P_1$ est appliqué le signal de sélection boîtier SB.

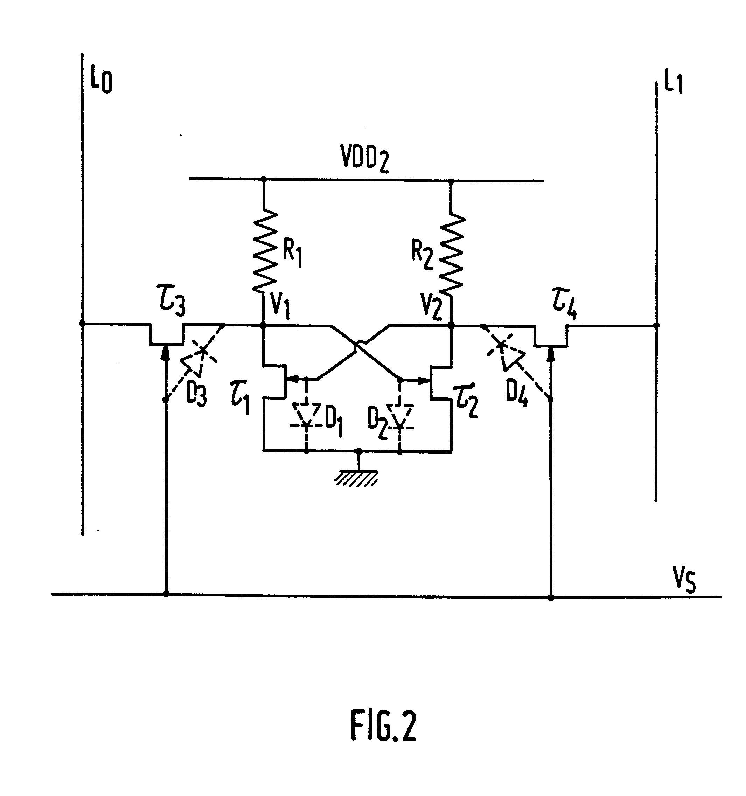

La charge de cette porte NON-OU $P_1$ est constituée par une résistance R réalisée par implantation de matériaux dopants dans le substrat en GaAs. La tension d'alimentation $VDD_1$ à laquelle est reliée cette charge R est d'une valeur de 1,2 Volt. Les transistors de cette porte NON-OU $P_1$ sont montés en source commune reliée à la masse. La sortie $V_A$ de la première porte NON-OU $P_1$ se fait au noeud A, sur les drains de ces transistors reliés à la charge R, et est appliquée sur la grille d'un transistor à effet de champ $T_0$ à enrichissement dont le drain est porté au potentiel $VDD_2$ et dont la source est reliée au noeud B, aux drains de $n+1$ transistors à effet de champ à enrichissement montés en parallèle et constituant ainsi une seconde porte NON-OU $P_2$. Les sources communes des transistors constituant $P_2$ sont portées à la masse. La tension $VDD_2$, d'une valeur de 0,7 Volt, est la tension d'alimentation des cellules mémoires, ainsi qu'il est montré figure 2.

Les n premières entrées de cette seconde porte NON-OU $P_2$ reçoivent les mêmes signaux codés d'adressage que la première porte NON-OU $P_1$. La dernière entrée de la porte $P_2$ reçoit le signal de sélection boîtier SB.

La sortie $V_S$ du décodeur élémentaire ou ligne de MOT se fait au noeud B, sur le drain commun des transistors de la porte $P_2$. Le signal de sortie $V_S$, en passant de 0 à 1, charge une capacité fictive $C_S$.

Lorsque toutes les entrées de $P_1$ sont à 0, la tension $V_A$, sur le noed A, peut monter pratiquement jusqu'à la valeur de la tension $VDD_1$. Le transistor $T_0$, sur la grille duquel cette tension $V_A$ est appliquée, devient conducteur. La capacité de sortie $C_S$ se charge par la tension $V_S$ qui devient alors très proche de la valeur $VDD_2$, les transistors de la porte $P_2$, qui reçoivent les mêmes signaux que ceux de la porte $P_1$, étant eux-mêmes bloqués.

Au contraire, lorsque l'une des entrées de la porte $P_1$ passe à 1, alors la valeur de la tension $V_A$ devient pratiquement nulle, puisque l'un des transistors sur lequel le signal "1" est appliqué devient conducteur. Une tension $V_A \approx 0$ est donc appliquée sur la grille du transistor $T_0$ qui est alors bloqué. Par contre, le même signal "1" est également porté sur l'un des transistors de la porte $P_2$ qui devient conducteur. Le transistor $T_0$ étant bloqué, la tension $V_S$ devient alors proche de 0, et la capacité $C_S$ se décharge rapidement.

Tel que représenté sur la figure 2, le "point mémoire" ou cellule mémoire est constitué de deux transistors $\tau_1$ et $\tau_2$ montés en bistable et alimentés à travers les résistances $R_1$ et $R_2$ respectivement par la tension d'alimentation $VDD_2$. Du fait de l'existence de diodes fictives $D_1$ et $D_2$, entre les grilles respectives de ces transistors et la masse, dues au fait que les transistors $\tau_1$ et $\tau_2$ sont du type Schottky, les signaux $V_1$ et $V_2$, sur les drains de ces derniers transistors, sont écrêtés à la valeur de 0,7 volt.

Il suffit par conséquent d'alimenter les cellules de la mémoire par une tension $VDD_2$ de 0,7 volt, toute tension d'une valeur supérieure augmentant la consommation sans augmenter le rapport entre le signal et le bruit.

D'autre part, le niveau haut ou "1" du signal $V_S$, sur la ligne de MOT, ne doit pas non plus excéder 0,7 Volt, car cette tension serait alors écrêtée par les diodes fictives $D_3$ et $D_4$ qui apparaissent entre la grille des transistors d'accès $\tau_3$ et $\tau_4$, de type Schottky et la masse, ce qui perturberait le fonctionnement de la cellule mémoire, en mettant simultanément en conduction ces deux transistors $\tau_3$ et $\tau_4$. C'est la raison pour laquelle, le transistor $T_0$ du second étage du décodeur élémentaire est alimenté par la tension $VDD_2 = 0,7$ volt alimentant les cellules mémoires.

La résistance R, reliée à la tension d'alimentation $VDD_1 = 1,2$ voit est alors tout à fait suffisante pour la bonne polarisation de ce transistor $T_0$. On notera que le signal de sortie $V_S$ est obtenu, dans le circuit selon la présente invention, par la combinaison des signaux codés d'adressage, appliqués, selon le besoin, sous la forme, pour chaque signal, du signal vrai ou de son complémentaire sur les entrées des portes NON-OU.

Enfin, on remarquera que dans le circuit selon l'invention, le signal de sélection boîtier SB est appliqué de façon particulière sur des transistors équivalents à ceux qui reçoivent les signaux codés d'adressage.

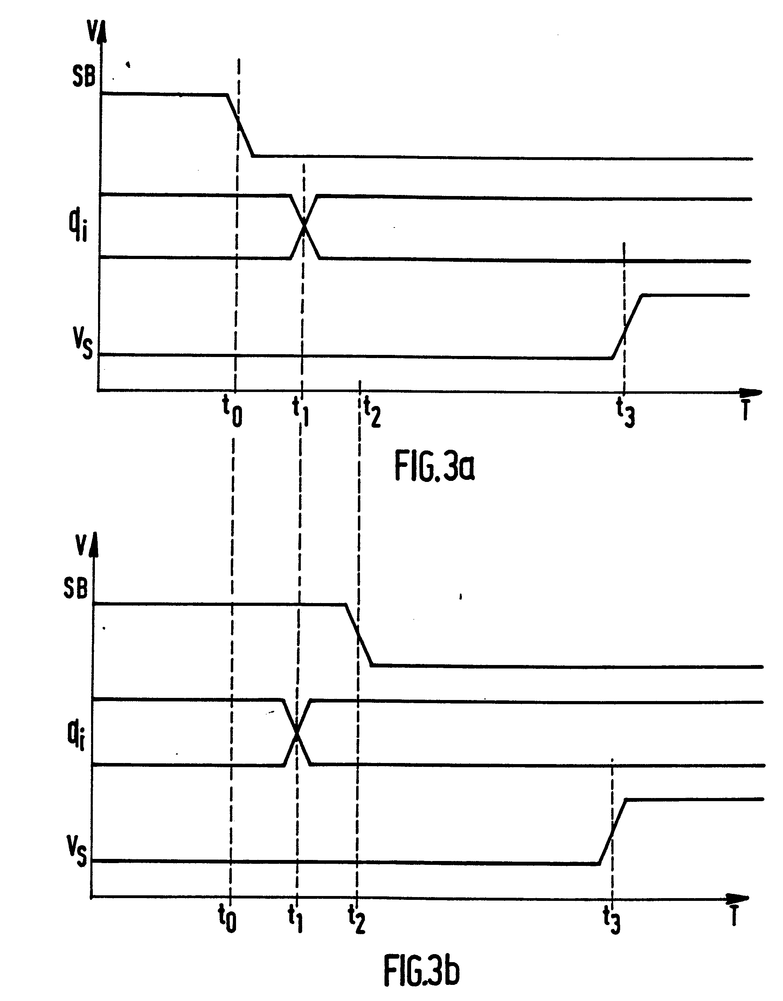

Or, comme il est montré sur les figures 3a et 3b, il existe deux modes de sélection d'un point mémoire. Selon le premier mode, dont le diagramme de propagation des signaux est représenté figure 3a, le signal de sélection boîtier est amené de l'état "1" à l'état "0" à l'instant $t_0$, tandis que la sélection ai d'une combinaison d'adresse $a_1$, $a_2...a_n$ est présenté à l'instant $t_1$. Puis le signal de sortie $V_S$ apparaît alors à l'instant $t_3$ sur la ligne de MOT, $t_3$ étant défini par rapport à $t_1$ par la différence $t_a$

$$t_a = t_3 - t_1$$

Dans ce type de fonctionnement, ce délai $t_a$, ou temps d'accès par rapport à l'adressage, détermine la performance de la mémoire.

Ce délai $t_a$ est fonction du temps de propagation dans les circuits et ne peut être réduit pour un dimensionnement donné.

Selon le second mode, qui est le mode de fonctionnement selon l'invention, et dont le diagramme de propagation des signaux est représenté figure 3b, la sélection $a_i$ d'une combinaison d'adresse $a_1$, $a_2$, $a_n$ est appliquée à l'instant $t_1$.

Selon ce second mode de sélection, il est remarquable que le signal de sélection boîtier SB est appliqué à l'instant $t_2$, alors que le signal de sortie $V_S$ est toujours présent sur la ligne de MOT à l'instant $t_3$.

Le temps d'accès en mémoire est, dans ce second mode de fonctionnement donné par la différence:

$$T_{SB} = t_3 - t_2 < t_a = t_3 - t_1$$

Le circuit réalisé selon l'invention offre la possibilité de fonctionner suivant ce mode, qui permet un temps d'accès en mémoire très diminué.

Dans une réalisation du circuit selon l'invention, les résistances et les transistors présentent les caractéristiques suivantes:

| | |
|---|---|
| Résistance | $R = 20\ k\Omega$ |
| Longueur de grille des transistors | $L = 0,9\ \mu m$ |
| Largeur des transistors de la porte $P_1$ | $I = 7\ \mu m$ |
| Largeur des transistors de la porte $P_2$ | $I = 7\ \mu m$ |
| Largeur du transistor $T_0$ | $I = 17\ \mu m$ |
| Tension d'alimentation | $VDD_1 = 1,2\ V$ |
| Tension d'alimentation | $VDD_2 = 0,7\ V$ |
| Tension de pincement | $V_T = 0,1\ V$ |

En outre, dans la réalisation de la cellule mémoire, les résistance et transistors présentent les caractéristiques suivantes:

| | |
|---|---|
| Résistance de charge | $R_1 = R_2 = 20\ k\Omega$ |
| Longueur de grille des transistors | $L = 0,9\ \mu m$ |
| Largeur des transistors $\tau_1$ et $\tau_2$ | $I = 8\mu$ |
| Largeur des transistors $\tau_3$ et $\tau_4$ | $I = 11\ \mu$ |
| Tension de pincement | $V_T = 0,1\ V$ |

Dans ces conditions un temps de propagation de 0,2 ns est obtenu dans le circuit décodeur élémentaire selon l'invention.

Dans une application à une mémoire RAM statique, le circuit décodeur de cette mémoire est composé de $2^n$ circuits décodeurs élémentaires identiques réalisés selon l'invention pour activer les $2^n$ lignes de la mémoire, et de $2^p$ circuits décodeurs élémentaires identiques selon l'invention pour activer les $2^p$ colonnes de la mémoire.

## Revendications

1. Circuit décodeur pour mémoire RAM statique intégrée monolithiquement, et constitué d'une porte logique NON-OU ($P_1$), qui est formée d'une série de transistors à effet de champ dont les grilles reçoivent les $\underline{n}$ signaux codés d'adressage de la mémoire ou leurs complémentaires, dont les sources sont reliées à la masse et dont les drains sont interconnectés et forment la sortiee de la porte NON-OU ($P_1$), qui est reliée à une borne d'alimentation ($VDD_1$) par l'intermédiaire d'une charge et au est reliée à la grille d'un transistor d'un étage inverseur de sortie, caractérisé en ce que la source du transistor de l'étage inverseur est raccordée aux drains communs d'une deuxième série de transistors, qui forment une deuxième porte NON-OU ($P_2$), les drains communs formant la sortie du circuit décodeur et les sources des transistors de la deuxième série étant relées la masse, en ce que la deuxième série de transistors reçoit sur ses grilles les $\underline{n}$ signaux codés d'adressage et en ce que la première et la deuxième séries de transistors comportent un transistor de sélection, dont la grille reçoit le signal de sélection du boîtier (SB), ce signal se sélection de boîtier étant appliqué aux transistors de sélection après l'application des signaux codés d'adressage de mémoires aux deux portes NON-OU ($P_1$, $P_2$).

2. Circuit décodeur pour mémoire RAM statique intégrée monolithiquement selon la revendication 1, caractérsé en ce que les transistors sont tous du type à enrichissement et en ce que la charge de la première porte NON-OU ($P_1$) est une charge résistive.

3. Ciircuit décodeur pour mémoire RAM statique intégrée monolithiquement selon la revendication 1 ou 2, caractérisé en ce que la tension d'alimentation ($VDD_1$) pour première porte NON-OU ($P_1$) est plus haute que la tension d'alimentation ($VDD_2$) pour la deuxième porte NON-OU ($P_2$).

4. Circuit selon la revendication 2, caractérisé en ce que la longueur de grille des transistors est $L = 0,9\ \mu m$ et la tension de pincement de ces transistor est $V_T = 0,1\ V$.

5. Circuit selon la revendication 2 ou 4, caractérisé en ce que la valeur de la résistance est $R = 20\ K\ Ohm$.

6. Circuit selon la revendication 3, caractérisé en ce que la tension d'alimentation $VDD_1 = 1,2\ V$ et la tension d'alimentation $VDD_2 = 0,7\ Volt$.

7. Mémoire RAM statique intégrée monolithiquement, caractérisée en ce qu'elle comprend des circuits décodeurs selon l'une des revendications 1 à 6, intégrés monolithiquement et réalisés à l'aide de transistors à effet de champ en arséniure de gallium.

8. Mémoire RAM statique selon la revendication 7, caractérisée en ce qu'elle est réalisée à l'aide de transistors à effet de champ en arséniure de gallium et en ce que la tension d'alimentation des cellules mémoires est égale à la tension d'alimentation ($VDD_2$) des deuxièmes portes NON-OU ($P_2$) des circuits décodeurs.

## Patentansprüche

1. Decoder für monolithisch integrierten, statischen RAM-Speicher, bestehend aus einem logischen NICHT-UND-Gatter ($P_1$), das aus einer Reihe von Feldeffekttransistoren zusammengesetzt ist, deren Gate-Elektroden die codierten n Speicheradreßsignale oder ihre Ergänzungen empfangen, deren Source-Elektroden an Masse liegen und deren Drainelektroden miteinander verbunden sind und dabei den Ausgang des NICHT-UND-Gatters ($P_1$) bilden, der über eine Belastung mit einer Speiseklemme ($VDD_1$) und weiter mit dem Gate eines Transistors einer Ausgangs-Umkehrstufe verbunden ist, dadurch gekennzeichnet, daß die Source-Elektrode des Transistors der Umkehrstufe an die gemeinsamen Drainelektroden einer zweiten Reihe von Transistoren angeschlossen ist, die ein zweites NICHT-UND-Gatter ($P_2$) bilden, wobei die gemeinsamen Drainelektroden den Ausgang des Decoders bilden und die Source-Elektroden der Transistoren der zweiten Reihe an Masse liegen, daß die zweite Transistorreihe an ihren Gate-Elektroden die codierten n Adreßsignale empfangen, und daß die ersten und zweiten Transistorreihen einen Selektionstransistor enthalten, dessen Gate-Elektrode das Selektionssignal aus dem Bus (SB) empfängt, das nach dem Anlegen der codierten Speicheradreßsignale an die beiden NICHT-UND-Gatter ($P_1$, $P_2$) den Selektionstransistoren zugeführt wird.

2. Decoder für monolithisch integrierten, statischen RAM-Speicher nach Anspruch 1, dadurch gekennzeichnet, daß die Transistoren alle vom Anreicherungstyp sind, und daß die Belastung des ersten NICHT-UND-Gatters ($P_1$) eine Widerstandsbelastung ist.

3. Decoder für monolithisch integrierten, statischen RAM-Speicher nach Anspruch 1 oder 2, dadurch gekennzeichnet, daß die Speisespannung ($VDD_1$) zum ersten NICHT-UND-Gatter ($P_1$) höher ist als die Speisespannung ($VDD_2$) zum zweiten NICHT-UND-Gatter ($P_2$).

4. Decoder nach Anspruch 2, dadurch gekennzeichnet, daß die Gate-Länge L der Transistoren 0,9 µm und die Pinch-off-Spannung $V_T$ dieser Transistoren 0,1 V beträgt.

5. Decoder nach Anspruch 2 oder 4, dadurch gekennzeichnet, daß der Widerstandswert R 20 kOhm beträgt.

6. Decoder nach Anspruch 3, dadurch gekennzeichnet, daß die Spelsespannung $VDD_1$ 1,2 V und die Speisespannung $VDD_2$ 0,7 V betragen.

7. Monolithisch integrierter, statischer RAM-Speicher, dadurch gekennzeichnet, daß er monolithisch integrierte und mit Hilfe von Galliumarsenid-Feldeffekttransistoren verwirklichte Decoder nach einem oder mehreren der Ansprüche 1 bis 6 enthält.

8. Statischer RAM-Speicher nach Anspruch 7, dadurch gekennzeichnet, daß er mit Hilfe von GaAs-Feldeffekttransistoren verwirklicht ist, und daß die Speisespannung der Speicherzellen gleich der Speisespannung ($VDD_2$) der zweiten NICHT-UND-Gatter ($P_2$) der Decoder ist.

## Claims

1. A decoder circuit for an integrated monolithic static RAM memory, which circuit is formed by a logic NORgate ($P_1$) which is formed by a series of field effect transistors whose gates receive the n coded memory address signals or the complements thereof, the sources thereof being connected to ground whilst their drains are interconnected and constitute the output of the NOR-gate ($P_1$) which is connected to a supply terminal ($V_{DD1}$) via a load and which is connected to the gate of a transistor of an output inverter stage, characterized in that the source of the transistor of the inverter stage is connected to the common drains of a second series of transistors which form a second NOR-gate ($P_2$), the common drains forming the output of the decoder circuit, the sources of the transistors of the second series being connected to ground, the second series of transistors receiving the n coded address signals on their gates, the first and the second series of transistors comprising a selection transistor whose gate receives the chip-enable selection signal (SB), said chip-enable selection signal being applied to the selection transistors after application of the coded memory address signals to the two NOR-gates ($P_1$, $P_2$).

2. A decoder circuit for a static RAM memory which is integrated in monolithic form as claimed in Claim 1, characterized in that all transistors are of the enhancement type, the load of the first NOR-gate ($P_1$) being a resistive load.

3. A decoder circuit for a static RAM memory which is integrated in monolithic form as claimed in Claim 1 or 2, characterized in that the supply voltage ($V_{DD1}$) for the first NOR-gate ($P_1$) is higher than the supply voltage ($V_{DD2}$) for the second NOR-gate ($P_2$).

4. A circuit as claimed in Claim 2, characterized in that the length of the gate of the transistors is L = 0.9 µm, the pinch-off voltage of these transistors being $V_T$ = 0.1 V.

5. A circuit as claimed in Claim 2 or 4, characterized in that the value of the resistor is R = 20 Kohms.

6. A circuit as claimed in Claim 3, characterized in that the supply voltage $V_{DD1}$ = 1.2 V, the supply voltage $V_{DD2}$ being 0.7 V.

7. A static RAM memory integrated in monolithic form, characterized in that it comprises decoder circuits as claimed in one of the Claims 1 to 6, said circuits being integrated in monolithic form using gallium arsenide field effect transistors.

8. A static RAM memory as claimed in Claim 7, characterized in that it is formed using gallium arsenide field effect transistors, the supply voltage for the memory cells being equal to the supply voltage ($V_{DD2}$) for the second NOR-gates ($P_2$) of the decoder circuits.

FIG.1

FIG.2

FIG.3a

FIG.3b